Europäisches Patentamt

European Patent Office

Office européen des brevets

(19)

(11) Veröffentlichungsnummer : **0 413 038 B1**

(12)
# EUROPÄISCHE PATENTSCHRIFT

(45) Veröffentlichungstag der Patentschrift :
**21.09.94 Patentblatt 94/38**

(51) Int. Cl.⁵ : **G11C 19/00, G11C 19/28, H03K 3/288**

(21) Anmeldenummer : **89115059.1**

(22) Anmeldetag : **16.08.89**

(54) **Zweiphasengesteuertes Schieberegister in Bipolartechnik.**

(43) Veröffentlichungstag der Anmeldung :
**20.02.91 Patentblatt 91/08**

(45) Bekanntmachung des Hinweises auf die
Patenterteilung :
**21.09.94 Patentblatt 94/38**

(84) Benannte Vertragsstaaten :
**DE FR GB IT NL**

(56) Entgegenhaltungen :
**CH-A- 1 570 069**

(56) Entgegenhaltungen :
**DE-A- 3 302 248**
**IBM TECHNICAL DISCLOSURE BULLETIN,**
**Band 15, Nr. 2, Juli 1972, Seiten 501-502, New**
**York, US; H.H. BERGER et al.: "Charge sense**
**and transfer scheme"**

(73) Patentinhaber : **Deutsche ITT Industries GmbH**
**Hans-Bunte-Strasse 19**
**D-79108 Freiburg (DE)**

(72) Erfinder : **Höhn, Wolfgang, Dipl.-Ing.**
**Löwenstrasse 3**
**D-7811 St. Märgen (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein zweiphasengesteuertes Schieberegister in Bipolartechnik nach den Merkmalen des Oberbegriffs des Patentanspruchs 1.

Ein derartiges bipolares Schieberegister ist beispielsweise aus der deutschen Offenlegungsschrift DE-A 33 02 248 bekannt, bei dem eine n-stufige Schieberegisterkette aus 2n in Reihe geschalteten Grundzellen besteht, die alternierend an einen ersten bzw. an einen nichtüberlappenden zweiten Schiebetakt angeschlossen sind. Jeweils zwei aufeinanderfolgende Grundzellen bilden eine der n Schieberegisterstufen. Durch die nichtüberlappenden Schiebetakte wird erreicht, daß in jeder Schieberegisterstufe die Datenübernahme zeitlich von der Datenweitergabe durch Zwischenspeicherung getrennt wird. Die beiden nichtüberlappenden Schiebetakte werden in einem Taktgenerator aus den beiden Ausgangssignalen eines Differenzverstärkers erzeugt, dessen Eingang ein Rechtecksignal zugeführt ist. Die verwendete Grundzelle besteht aus einem Doppelemitter-npn-Transistorpaar, dessen Basis- und Kollektoranschlüsse über Kreuz verkoppelt sind und an dessen beiden Zusatzemittern das Datensignal gegenphasig ausgekoppelt wird.

Aufgabe der in den Ansprüchen gekennzeichneten Erfindung ist es, ein zweiphasengesteuertes Schieberegister mit großem Frequenzumfang und neutralem Temperaturverhalten in Bipolartechnik anzugeben, bei dem der gesamte Schieberegisterinhalt parallel mittels eines Übernahmetaktes in eine Ausgangspufferschaltung eingelesen werden kann und dort als Datenwort beliebige Zeit zur Verfügung steht.

Diese Aufgabe wird gelöst wie ein Anspruch 1 angegeben.

Ein Vorteil der Erfindung ist, daß die gesamte Schieberegisteranordnung lediglich durch Änderung von zwei Widerständen an einen weiten Frequenzbereich angepaßt werden kann. Dabei hat die Umgebungstemperatur nahezu keinen Einfluß auf die Zeitdauer des Nichtüberlappungsbereiches. Damit bleibt die Funktion des Schieberegisters in einem weiten Temperaturbereich erhalten, ohne daß aus Sicherheitsgründen die Taktfrequenz reduziert werden muß. Ein weiterer Vorteil ist, daß durch Maßnahmen im Layout sichergestellt ist, daß die Layoutgeometrie linear verkleinerbar ist, weil die Empfindlichkeit gegen höhere Versorgungsspannungen und die davon abhängigen parasitären Effekte reduziert sind. Beispielsweise wird dadurch die sichere Schieberegisterfunktion auch bei einer Technologie gewährleistet, die für andere mitintegrierte Schaltungsteile eine zulässige Kollektor-Emitter-Sperrspannung von mehr als 40 V aufweist.

Die Erfindung und weitere Vorteile werden nun anhand der Figuren der Zeichnung näher erläutert:

Fig.1 zeigt die schematische Anordnung eines n-stufigen Schieberegisters mit n-Ausgangspufferstufen und einem Taktgenerator für den nichtüberlappenden Zweiphasentakt,

Fig.2 zeigt als ein vorteilhaftes Ausführungsbeispiel das Schaltbild des Taktgenerators und einer der n-Schieberegisterstufen,

Fig.3 zeigt die Strompfade der Grundzelle bei der Datenübernahme,

Fig.4 zeigt die Strompfade der Grundzelle im Verriegelungszustand,

Fig.5 zeigt einige Signalverläufe zur Erläuterung der Zweiphasentakterzeugung und

Fig.6 zeigt schließlich in schematischer Layout-Aufsicht-Darstellung einen sättigungsfesten npn-Transistor.

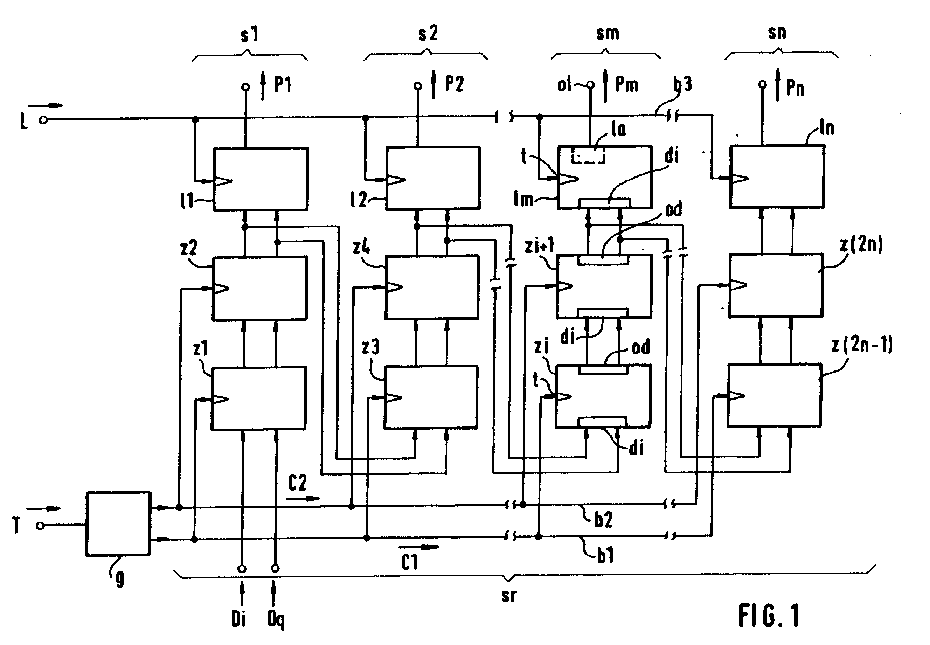

Im Blockschaltbild von Fig.1 sind 2n Grundzellen $z_1$, $z_2$, $z_3$, $z_4$, ..., $z_i$, $z_{i+1}$, ..., $z_{(2n-1)}$, $z_{(2n)}$ in Signalflußrichtung hintereinandergeschaltet, wobei der ersten Grundzelle $z_1$ ein gegenphasiges Datenpaar Di, Dq zugeführt ist. Jede Grundzelle $z_i$ ist dabei als statisch getaktetes Speicherelement ausgeführt, beispielsweise als RS-Flipflop mit kreuzgekoppelten Transistoren. Alle ungeradzahligen Grundzellen $z_1$, $z_3$, ..., $z_i$, $z_{(2n-1)}$ liegen mit ihrem Takteingang t an einem ersten Schiebetakt C1, der über eine erste Taktleitung b1 an einen Taktgenerator g angekoppelt ist. Alle restlichen Grundzellen $z_2$, $z_4$, ..., $z_{i+1}$, ..., $z_{(2n)}$, nämlich die geradzahligen, liegen mit ihrem Takteingang t an einem zweiten Schiebetakt C2, der über eine zweite Taktleitung b2 an den Taktgenerator g angekoppelt ist. Der Eingang des Taktgenerators g ist mit einem Rechtecksignal T gespeist.

Jeweils eine ungeradzahlige und eine unmittelbar nachfolgende geradzahlige Grundzelle $z_1$, $z_2$; $z_3$, $z_4$; ...; $z_i$, $z_{i+1}$; ...; $z_{(2n-1)}$, $z_{(2n)}$ bilden eine Schieberegisterstufe, so daß aus den 2n Grundzellen der Schieberegisterkette sr ein Schieberegister mit n Schieberegisterstufen $s_1$, $s_2$, ..., $s_m$, ..., $s_n$ gebildet wird. Nach jeweils einer Taktperiode ist der gesamte Schieberegisterinhalt um jeweils eine Schieberegisterstufe weitergeschoben.

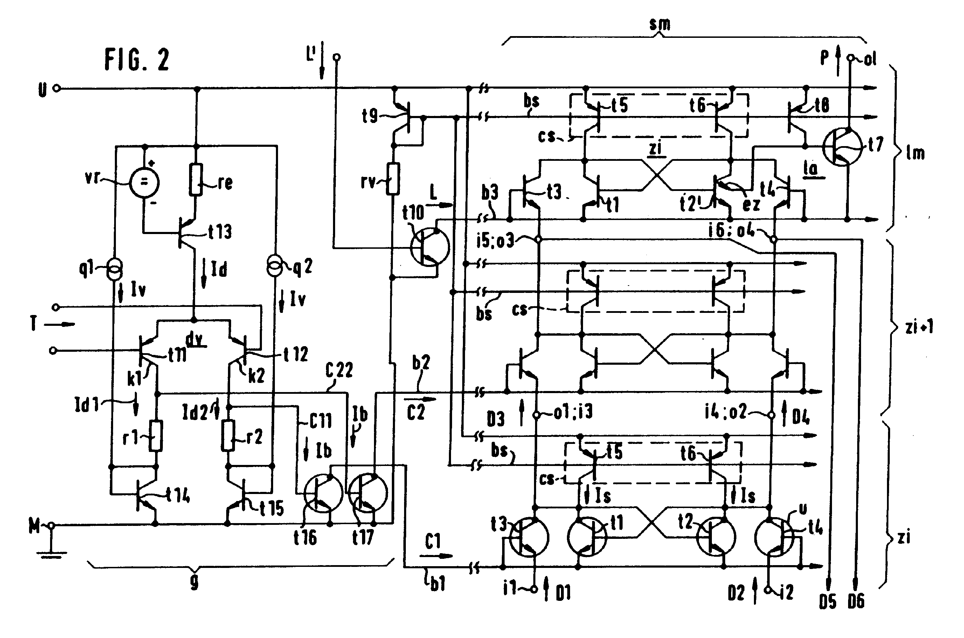

Jede Grundzelle $z_i$ der Schieberegisterkette sr weist einen gegenphasigen Dateneingang di und einen gegenphasigen Datenausgang od auf, wobei die jeweils unmittelbar nachfolgende Grundzelle $z_{i+1}$ mit ihrem gegenphasigen Dateneingang di direkt an den gegenphasigen Datenausgang od der ihr vorangehenden Grundzelle $z_i$ angeschlossen ist. Der gegenphasige Datenausgang od jeder ungeradzahligen Grundzelle $z_{i+1}$ ist ferner dem gegenphasigen Dateneingang di einer Ausgangspufferstufe lm zugeführt, die von einem Übernahmetakt (= latch-Takt) L gesteuert ist. Jeder Schieberegisterstufe $s_1$, $s_2$, ..., $s_m$..., $s_n$ ist eine Ausgangspufferstufe (= latch) l1, l2, ..., lm,..., ln mit jeweils einer Auskoppelstufe la zugeordnet, an welcher das jeweilige ausgekoppelte Datensignal P1, P2, ..., Pm, ..., Pn abgreifbar ist. Der Einfachheit halber sind in Fig.1, sowie in der nachfolgenden Figur 2, lediglich die Auskoppelstufen la für eine einzige Datenphase gezeigt. Sollen gegenphasige Datensignale ausgekoppelt werden, dann wird die Auskoppelstufe la durch eine zweite, symmetrisch angeschlossene Auskoppelstufe ergänzt.

In Fig.2 ist als Schaltbild ein besonders vorteilhaftes Ausführungsbeispiel des Taktgenerators g und einer der n-Schieberegisterstufen sm dargestellt. Jede Schieberegisterstufe sm enthält dabei zwei hintereinandergeschalteten Grundzellen $z_i$, $z_{i+1}$ und eine an die letztere Grundzelle angeschlossene Ausgangspufferstufe lm. Alle drei Schaltungseinheiten der Schieberegisterstufe enthalten als wesentliche Baugruppe ein RS-Flipflop, das aus einem kreuzgekoppelten npn-Transistorpaar, nämlich dem ersten und dem zweiten Transistor $t_1$, $t_2$, beide von einem ersten Typ, und einem dritten und einem vierten Transistor $t_3$, $t_4$, ebenfalls vom ersten Typ, besteht. Die Kollektoren des ersten und zweiten Transistors $t_1$ $t_2$ sind aus einer Strombank cs, nämlich einer pnp-Strombank, die als Stromquellen einen fünften und einen sechsten Transistor $t_5$, $t_6$ vom zweiten Typ enthält, gespeist, wobei die Basisanschlüsse aller Stromquellen-Transistoren über eine gemeinsame Basisleitung bs zusammengeschaltet sind. Dabei speist der fünfte bzw. der sechste Transistor $t_5$, $t_6$ den Kollektor des ersten bzw. des zweiten Transistors $t_1$, $t_2$. Der jeweilige Ausgangsstrom der Strombank cs ist der Strombankstrom = Is).

Die logische Umsteuerung des kreuzgekoppelten Transistorpaares $t_1$, $t_2$ ist durch den dritten bzw. vierten Transistor $t_3$, $t_4$ bewirkt, dessen Kollektor mit dem Kollektor des ersten bzw. mit dem Kollektor des zweiten Transistors $t_1$, $t_2$, also eine ODER-Verknüpfung, zusammengeschaltet ist. Die Basisanschlüsse des dritten und des vierten Transistors $t_3$, $t_4$ und die Emitteranschlüsse des ersten und des zweiten Transistors $t_1$, $t_2$ liegen gemeinsam an einer Taktleitung. In der dargestellten Grundzelle $z_i$ ist dies die erste Taktleitung b1, über die der erste Schiebetakt C1 der Grundzelle $z_i$ zugeführt ist.

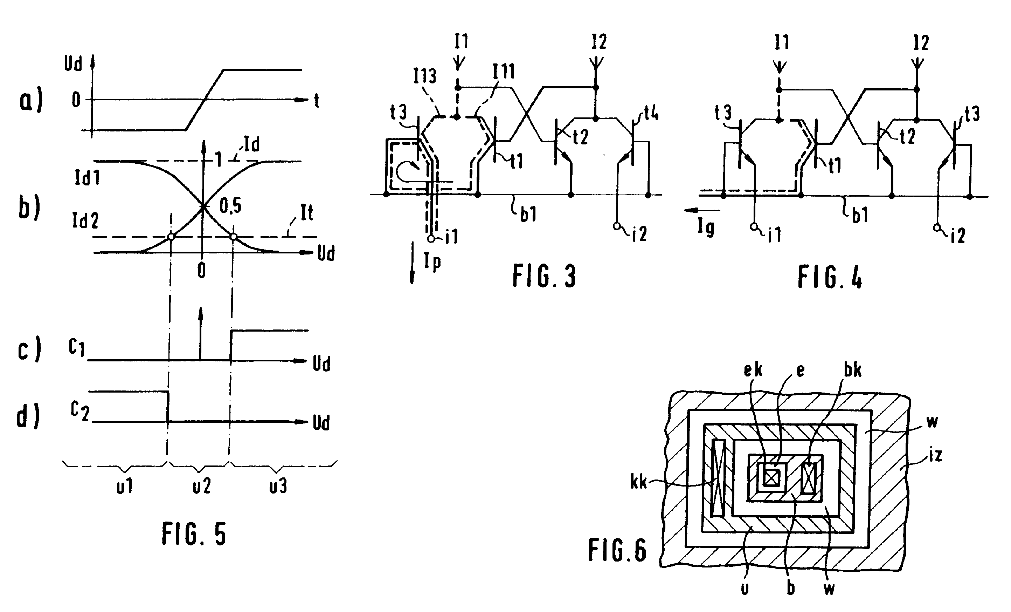

Der erste Schiebetakt C1 ist dabei von einem npn-Schalttransistor, nämlich dem sechzehnten Transistor $t_{16}$ vom ersten Typ, gebildet, dessen Emitter auf einem gemeinsamen Masseanschluß M liegt und dessen Kollektor an die erste Taktleitung b1 angeschlossen ist. Die Basis des npn-Schalttransistors $t_{16}$ ist dabei aus dem Taktgenerator g mit einem vom Rechtecksignal T abgeleiteten rechteckförmigen ersten Signal C11 angesteuert. Somit ist in der durchgeschalteten Phase des npn-Schalttransistors $t_{16}$ die erste Taktleitung b1 niederohmig auf das Potential des Masseanschlusses M durchgeschaltet. In der sperrenden Phase des npn-Schalttransistores $t_{16}$ verbleibt die erste Taktleitung b1 hingegen im stromlosen "Schwebezustand". In Fig.3 wird später dargestellt, daß in diesem "Schwebezustand" der Strombankstrom Is trotzdem einen Stromfluß auf der ersten Taktleitung b1 bewirkt, nämlich über die Basis-Emitterstrecke des ersten und des dritten Transistors $t_1$, $t_3$. Nur während des "Schwebezustandes" kann die jeweilige Grundzelle Daten von der vorausgehenden Grundzelle übernehmen. Bei durchgeschaltetem npn-Schalttransistor $t_{16}$ bleibt der Dateninhalt der Grundzelle stabil - die Grundzelle ist im "Verriegelungszustand"

Der gegenphasige Dateneingang di der in Fig.2 dargestellten Grundzelle $z_i$ wird durch den Emitter des dritten und des vierten Transistors $t_3$, $t_4$ gebildet, wobei der Emitter des dritten bzw. vierten Transistors $t_3$, auf eine erste bzw. eine zweite Eingangsklemme i1, i2 geführt ist. Der ersten bzw. der zweiten Eingangsklemme i1, i2 ist das erste bzw. das zweite (gegenphasige) Dateneinangssignal D1, D2 zugeführt. Der gegenphasige Datenausgang od der Grundzelle ist durch eine erste und eine zweite Ausgangsklemme o1, o2 gebildet, wobei die Kollektoren des ersten und dritten bzw. des zweiten und vierten Transistors $t_1$, $t_3$; $t_2$, $t_4$ mit der ersten bzw. zweiten Ausgangsklemme o1, o2 verbunden sind. An der ersten bzw. an der zweiten Ausgangsklemme o1, o2 ist das dritte bzw. das dazu gegenphasige vierte Datenausgangssignal D3, D4 der Grundzelle $z_i$ abgreifbar.

In Fig.2 ist die erste bzw. zweite Ausgangsklemme o1, o2 der Grundzelle $z_i$ identisch mit der jeweiligen Eingangsklemme der unmittelbar nachfolgenden Grundzelle i3, i4, die jeweils auf den Emitter des zugehörigen Transistors $t_3$, $t_4$ zur Ansteuerung dieser Grundzelle $z_{i+1}$ geführt sind. Der Schiebetakt dieser Grundzelle $z_{i+1}$ ist dieser auf einer zweiten Taktleitung b2 zugeführt, die von einem weiteren npn-Schalttransistor, nämlich dem siebzehnten Transistor $t_{17}$ vom ersten Typ, gegenphasig und nichtüberlappend zum ersten Schiebetakt C1 gesteuert ist und somit den zweiten Schiebetakt C2 bildet. Die Basis des siebzehnten Transistors $t_{17}$ ist von einem zweiten Signal C22 angesteuert, das im Taktgenerator g erzeugt ist.

Der gegenphasige Datenausgang od dieser Grundzelle $z_{i+1}$, nämlich einer geradzahligen, ist durch die dritte bzw. vierte Ausgangsklemme o3, o4 gebildet, an der das fünfte bzw. das gegenphasige sechste Datenausgangssignal D5, D6 für die nachfolgende Schieberegisterstufe abgegriffen ist.

Die dritte bzw. vierte Ausgangsklemme o3, o4 sind in Fig.2 zugleich als fünfte bzw. als sechste Eingangsklemme i5, i6 für den gegenphasigen Dateneingang di der Ausgangspufferstufe (= latch) dargestellt.

Die Ausgangspufferstufe lm enthält als Teilschaltung die vollständige Grundzelle $z_i$ und eine Auskoppelstufe la für das auszukoppelnde Datensignal P. Meist reicht es aus, dieses Datensignal P lediglich als Einphasensignal am zweiten Transistor $t_{2'}$ der Grundzelle $z_i$ auszukoppeln. Bei einer gewünschten Zweiphasendarstellung des auszukoppelnden Datensignals P ist die Ausgangspufferstufe lm durch eine zur Auskoppelstufe la symmetrische weitere Auskoppelstufe am ersten Transistor t1 zu ergänzen.

Der zweite Transistor t2′ der Grundzelle zi in der Ausgangspufferstufe lm ist als Doppelemittertransistor zur Signalauskopplung ausgeführt. Der Zusatzemitter ez ist auf die Basis eines siebten Transistors t7 vom ersten Typ geführt, dessen Emitter auf die Taktleitung, nämlich die Übernahmetaktleitung b3, der Ausgangspfufferstufe lm geführt ist. Der Kollektor dieses siebten Transistors t7 ist auf die latch-Ausgangsklemme ol geführt, an der das auszukoppelnde Datensignal P abgreifbar ist. Der Basisstrom des siebten Transistors t7 wird durch den Kollektorstrom eines achten Transistors t8 vom zweiten Typ geliefert, dessen Basis parallel zu dem fünften und sechsten Transistor t5, t6 der Strombank cs an die gemeinsame Basisleitung bs angeschlossen ist. Dabei ist die wirksame Kollektorgröße dieses achten Transistors t8 im Layout so bemessen, daß sein Kollektorstrom etwa ein Fünftel des Strombankstroms ls beträgt. Dies reicht in jedem Fall zur Basisansteuerung des siebten Transistors t7 aus. Der Strom kann auch durch andere Maßnahmen, wie Emittergegenkopplung, verkleinert sein. Somit umfaßt die Auskoppelstufe la den siebten und achten Transistor t7, t8 und den Zusatzemitter ez des zweiten Transistors t2′ der Grundzelle zi.

Die dritte Taktleitung b3 mit dem Übernahmetakt L ist von einem dritten npn-Schalttransistor, nämlich dem zehnten Transistor t10 vom ersten Typ gesteuert, dessen Basis ein Übernahmesignal L′ zugeführt ist. Der Übernahmetakt L muß während der Übernahmephase gegenphasig und nichtüberlappend zum zweiten Schiebetakt C2 sein. Er kann also mit dem ersten Schiebetakt C1 zeitlich gekoppelt oder gar identisch sein.

Der Taktgenerator g in Fig.2 erzeugt aus einem gegenphasig zugeführten Rechtecksignal T mittels eines Differenzverstärkers dv und weiterer Teilschaltungen die beiden gegenphasigen Schiebetakte C1, C2. Der Differenzverstärker dv enthält als pnp-Transistorpaar einen elften und zwölften Transistor t11, t12 vom zweiten Typ, deren gemeinsamer Emitteranschluß von einer Konstantstromquelle vr, re, t13 gespeist ist. Die Konstantstromquelle besteht dabei aus einem dreizehnten Transistor t13 vom zweiten Typ, dessen Emitter über einen Emitterwiderstand re und dessen Basis über eine Referenzspannungsquelle vr an die positive Versorgungsspannung U angeschlossen sind. Als Referenzspannungsquelle vr kann beispielsweise eine der bekannten Bandgap-Schaltungen mit vorgebbarem Temperaturverhalten dienen, so daß der Ausgangsstrom ld der Konstantstromquelle temperaturunabhängig wird.

Das Rechtecksignal T bewirkt über den Differenzverstärker dv eine Aufteilung des Ausgangsstroms der Konstantstromquelle, nämlich des Kon-

stantstromquellen-Stroms ld, in einen ersten und einen zweiten Differenzstrom ld1, ld2 mittels des elften bzw. zwölften Transistor t11 , t12; in Fig.5 ist diese Aufteilung als Funktion der Differenzspannung Ud graphisch dargestellt.

Für die gegenphasige Takterzeugung ist im einfachsten Fall (eine eigene Darstellung erübrigt sich hierzu) der Kollektor k1 , k2 des elften bzw. zwölften Transistors t11, t12 über einen Lastwiderstand mit dem Masseanschluß M verbunden. Ferner ist der Kollektor k1 , k2 des elften bzw. zwölften Transistors t11, t12 mit der Basis des sechzehnten bzw. siebzehnten Transistors t16, t17, nämlich den beiden npn-Schalttransistoren für die beiden Schiebetakte C1, C2, verbunden. Die Größe der beiden Lastwiderstände bestimmt die Nichtüberlappungszeit der beiden Schiebetakte C1, C2, aber auch die Ausräumzeit der npn-Schalttransistoren Erzeugt beispielsweise bei der Stromübernahme der Kollektor k1 an seinem Lastwiderstand einen Spannungsabfall, der größer als die Basis-Emitter-Schwellenspannung des sechzehnten Transistors t16 ist, also etwa 0,6 V, dann schaltet dieser Transistor in den leitenden Zustand und die erste Taktleitung b1 wird niederohmig nahezu auf das Potential des Masseanschlusses M durchgeschaltet. Ein Nachteil dieser Anordnung ist indessen, daß die Basis-Emitter-Schwellenspannung der npn-Schalttransistoren temperaturabhängig ist, so daß der Nichtüberlappungsbereich und damit die Nichtüberlappungszeit ebenfalls temperaturabhängig sind.

Diesen Nachteil beseitigen erfindungsgemäß die beiden als Dioden geschalteten Transistoren vom ersten Typ, nämlich der vierzehnte bzw. der fünfzehnte Transistor t14, t15. In Fig.2 ist beispielsweise der gemeinsame Basis-Kollektoranschluß des vierzehnten Transistors t14 über einen ersten Widerstand r1 mit dem Kollektor k1 des elften Transistors t11 verbunden. Zusätzlich ist der gemeinsame Basis-Kollektoranschluß über eine erste Vorstromquelle q1 an die positive Versorgungsspannung U angeschlossen, wobei die Vorstromquelle q1 einen konstanten Vorstrom lv in die Diode speist. Der Emitter des vierzehnten Transistors t14 ist auf den Masseanschluß M geführt. In gleicher Weise ist der gemeinsame Basis-Kollektoranschluß des fünfzehnten Transistors t15 über einen zweiten Widerstand r2 auf den Kollektor k2 des zwölften Transistors t12 geführt, wobei der gemeinsame Basis-Kollektoranschluß des fünfzehnten Transistors t15 zusätzlich über eine zweite Vorstromquelle q2 mit einem konstanten Vorstrom lv gespeist ist, der gleichgroß wie der Vorstrom lv der ersten Vorstromquelle q1 ist.

Der Vorstrom lv ist etwa um den Faktor 10 bis 1000 kleiner als der Konstantstromquellen-Strom ld. Dabei ist der Konstantstronquellen-Strom ld vorteilhaft so zu bemessen, daß sein Wert etwa zwei- bis fünfmal so groß wie der erforderliche Basisstrom (= lb) eines der beiden npn-Schalttransistoren t16, t17 ist. Der erforderliche Basisstrom Ib ergibt sich aus der Anzahl n der Schieberegisterstufen, dem Wert des Strombankstroms = IS) und dem Gleichstromverstärkungsfaktor (= B) im Schaltbetrieb nach folgender Gleichung:

$$Ib = 2nIs/B.$$

Für die Bemessung des Konstantstromquellen-Stroms Id ergibt sich somit folgende Bemessungsregel:

$$4nIs/B \leqq Id \leqq 10nIs/B.$$

Der Vorstrom Iv hält die Diodenspannung des vierzehnten und des fünfzehnten Transistors t14, t15 auf einem Wert, der etwas unter der Basis-Emitter-Schwellenspannung der beiden npn-Schalttransistoren t16, t17 liegt. Dabei ist die Temperaturabhängigkeit der Diodenspannung und der Basis-Emitter-Schwellenspannung der npn-Schalttransistoren nahezu gleich. Der Temperaturkoeffizient dieser Differenzspannung beträgt bekanntlich nur noch 3,3 Promille pro Grad Kelvin. Dieser Wert kann jedoch durch entsprechende Abstimmung der Referenzspannungsquelle vr auch noch verbessert werden.

Als weiterer Vorteil bewirkt die Verwendung der Dioden und der niederohmigen Widerstände r1, r2 eine Verringerung des Miller-Effekts an den beiden npn-Schalttransistoren t16, t17 im Ausschaltbereich, wo deren Basis-Emitterstrecken noch sehr hochohmig sind. Der niederohmige Lastwiderstand und die Hubverringerung wirken sich gleichfalls günstig auf die Hochfrequenzeigenschaften des Differenzverstärkers dv aus, indem ebenfalls sein nachteiliger Miller-Effekt verringert wird. In Fig.2 ist die Strombank cs auf einfachste Weise an einen neunten Transistor t9 vom zweiten Typ angeschlossen, der als Diode geschaltet ist und dessen gemeinsame Basis-Kollektor-Strecke sowohl mit der gemeinsamen Basisleitung bs aller Strombänke cs als auch über einen Vorwiderstand rv mit dem Masseanschluß M verbunden ist.

In Fig.3 sind die Strompfade in der Grundzelle bei der Datenübernahme gezeigt. Das ist der Zustand, in dem die zugehörige Taktleitung im Schwebezustand ist, wobei der Schiebetakt den oberen Spannungspegel aufweist. Im dargestellten Beispiel ist also die erste Taktleitung b1 im Schwebezustand und an der ersten Eingangsklemme i1 liegt ein Dateneingangssignal an, das diese Klemme in Richtung des Masseanschlusses M zieht. An dieser Klemme fließt somit ein Datenstrom Ip. An der zweiten Eingangsklemme i2 liegt das gegenphasige Dateneingangssignal an, somit ist diese Klemme stromlos. Der Datenstrom Ip setzt dabei das Flipflop aus dem ersten und zweiten Transistor t1, t2 zwangsweise in den gewünschten Logikzustand.

Der von der Strombank cs gelieferte Strom hat folgenden Stromverlauf. Der dem Kollektor des ersten und dritten Transistors t1, t3 zugeführte Strombankstrom ist der erste Strombankstrom I1, der sich in einen ersten Teilstrom I11, der über den Kollektor des ersten Transistors t1 fließt, und in einen zweiten Teilstrom I13, der über den Kollektor des dritten Transistors t3 fließt, aufteilt. Der erste Teilstrom I11 fließt über die Kollektor-Emitterstrecke des ersten Transistors t1 in die erste Taktleitung b1 und von dort über die Basis-Emitterstrecke des dritten Transistors t3 in die erste Eingangsklemme i1. Der zweite Teilstrom I13 fließt über die Kollektor-Emitterstrecke des dritten Transistors t3 direkt in die erste Eingangsklemme i1.

Der zweite und der vierte Transistor t2, t4 sind in dem angenommenen Schaltzustand gesperrt, so daß der zweite Strombankstrom I2, der auf den Kollektor des zweiten und vierten Transistors t2, t4 geführt ist, von diesen nicht abgenommen werden kann. Der zweite Strombankstrom I2 fließt daher über die Basis-Emitterstrecke des ersten Transistors t1 in die erste Taktleitung b1 und von dort über die Basis-Emitterstrecke des dritten Transistors t3 in die erste Eingangsklemme i1.

In Fig.4 ist der Schaltzustand dargestellt, wenn die Taktleitung durch den zugehörigen npn-Schalttransistor durchgeschaltet ist, sich also nahezu auf dem Potential des Masseanschlusses M befindet. Die vorangehende, in der Fig.4 nicht dargestellte Grundzelle, befindet sich dabei im stromlosen Zustand, so daß über die beiden Datenleitungen an den beiden Eingangsklemmen i1, i2 kein Strom abgenommen werden kann. Der erste Strombankstrom I1 fließt somit über die durchgeschaltete Kollektor-Emitterstrecke des ersten Transistors t1 in die erste Taktleitung b1. Der zweite Strombankstrom I2 fließt über die Basis-Emitterstrecke des ersten Transistors t1 ebenfalls in die erste Taktleitung b1. Der Gesamtstrom Ig der ersten Taktleitung b1 wird vom nicht dargestellten npn-Schalttransistor auf den Masseanschluß M geschaltet.

Fig.5 zeigt einige Signalverläufe zur Erläuterung der Zweiphasentakterzeugung im Taktgenerator g. Dem Rechtecksignal T entspricht dabei das Differenzsignal Ud, das die wirksame Differenzspannung am Differenzverstärker dv darstellt. Im Zeitdiagramm 5a ist dargestellt, daß diese Differenzspannung Ud in einem endlichen Zeitbereich vom einen Zustand in den andern übergeht.

Im Diagramm nach Fig.5b wird dargestellt, wie der Konstantstromquellen-Strom Id in einen ersten und einen zweiten Teilstrom Id1, Id2 in Abhängigkeit von der Differenzspannung Ud aufgeteilt wird. Die lineare Darstellung entspricht der bekannten Stromaufteilung bei bipolaren Differenzverstärkern. In das Diagramm 5b ist der Schwellenstrom It eingezeichnet, bei der der jeweilige Teilstrom ausreicht, um an seiner Widerstandsdiodenstrecke r1, t14; r2, t15 einen so großen Spannungsabfall zu erzeugen, daß der nachgeschaltete npn-Schalttransistor durchgesteuert wird. Je nach der Wahl dieses Schwellenstroms It, kann somit der Nichtüberlappungsbereich verändert werden. Bleiben durch schaltungstechnische Maßnahmen der Verlauf der Differenzspannung Ud, der Verlauf der beiden Teilströme Id1 , Id2 und der Schwellenstrom It konstant, dann ändert sich auch der Nichtüberlappungsbereich nicht. Der Nichtüberlappungsbereich hängt natürlich von der Steilheit der Taktflanke der Differenzspannung Ud ab. Je kürzer die Dauer der Taktflanke ist, desto kleiner wird der Nichtüberlappungsbereich.

Im Diagramm 5c bzw. 5d ist der Spannungspegel des ersten bzw. zweiten Schiebetaktes C1, C2 in Abhängigkeit von der Differenzspannung Ud angegeben. Der jeweilige Umschaltpunkt ergibt sich aus dem Schnittpunkt des Schwellenstroms It mit dem ersten oder zweiten Teilstrom Id1, Id2. Im angegebenen Beispiel ist erkennbar, daß während des ersten Zeitintervalls u1 lediglich der zweite Schiebetakt C2 im Schwebezustand ist, also auf hohem Potential liegt. Im zweiten Zeitintervall u2, dem Nichtüberlappungsbereich, liegen beide Schiebetakte C1, C2 auf niederem Potential, sind also im Verriegelungszustand. Im dritten Zeitintervall u3 befindet sich nur der erste Schiebetakt C1 im Schwebezustand, also auf hohem Potential.

In Fig.6 ist schematisch in Aufsicht das Layout eines npn-Transistors dargestellt, also eines Transistors vom ersten Typ. Wie die Fig.3 und 4 zeigen, arbeiten diese Transistoren teilweise in einem Übersteuerungsbereich, bei dem der Gleichstromverstärkungsfaktor B bis auf den Wert 1 heruntergeht. Dies führt zu einer starken Sättigung dieser Transistoren, so daß die Gefahr von parasitären Strömen besteht. Da diese wegen der vorhandenen burried-layer-Schicht (= vergrabene Schicht) weniger in vertikaler als in lateraler Richtung fließen, wird die Basiszone b von einer niederohmigen Ringzone u von $n^+$-Material umgeben, die innerhalb der Kollektorwanne w liegt und diese auch kontaktiert. Laterale Ströme, die von der Basiszone b ausgehen, werden somit abgefangen und über den Kollektorkontakt kk abgeführt.

Fig.6 zeigt in Aufsicht die Emitterzone e mit dem Emitterkontakt ek, die Basiszone b mit dem Basiskontakt bk und die Kollektorwanne w, die in die Isolierzone iz aus $p^+$-Material eingebettet ist. Der niederohmige Kollektoranschluß erfolgt einmal durch die burried-layer-Schicht aus $n^+$-Material und die an der Oberfläche liegende Ringzone u. Diese Ringzone ist teilweise schematisch in Fig.2 als Ring um diejenigen Transistoren vom ersten Typ gezeichnet, die in Sättigung gehen. Der Übersichtlichkeit wegen ist die Ringzone u lediglich als Beispiel in der Grundzelle zi und in der Auskoppelstufe la dargestellt.

Die Anpassung des Schieberegisters an unterschiedliche Frequenzen erfolgt lediglich durch Änderung des Emitterwiderstandes re im Taktgenerator und durch Änderung des Vorwiderstand es rv im Steuerteil der Strombank cs. Bei höheren Taktfrequenzen werden durch Verkleinerung dieser Widerstände die der Umschaltung dienenden Ströme vergrößert, so daß die Schiebefunktion rascher abgeschlossen wird. Falls dabei die Flanke der Differenzspannung Ud steil genug ist, bleibt die Nichtüberlappung der beiden Schiebetakte C1, C2 unverändert erhalten.

## Patentansprüche

1. Zweiphasengesteuertes Schieberegister in Bipolartechnik mit
   - mit einem Taktgenerator (g), der mittels eines emittergekoppelten Differenzverstärkers (dv) aus einem zugeführten Rechtecksignal (T) einen ersten und einen zweiten Schiebetakt (C1, C2) erzeugt,
   - mit einer n-stufigen Schieberegisterkette (s1, s2, ..., sn), die aus 2n in Reihe geschalteten Grundzellen (z1, z2, ..., zi, zi+1,..., z(2n-1), z(2n)) besteht, deren jeweiliger Takteingang (t), von der ersten Grundzelle (z1) aus gezählt, alternierend vom ersten bzw. zweiten Schiebetakt (C1 , C2) gesteuert ist, wobei jeweils eine ungeradzahlige (z1 , z3, ..., z(2n-1)) und eine unmittelbar folgende geradzahlige Grundzelle (z2, z4,..., z(2n)) eine (sm) der n Schieberegisterstufen (s1 , s2,..., sm, ..., sn) bilden und wobei die Grundzelle einen ersten und einen zweiten Transistor (t1, t2) eines ersten Typs in Emitterkopplung enthält, deren jeweiliger Kollektor mit der Basis des anderen Transistors und mit jeweils einem Ausgang einer Strombank (cs) verbunden ist, gekennzeichnet durch folgende Merkmale:
      - der gegenphasige Dateneingang (di) jeder Grundzelle (zi) ist durch eine erste und eine zweite Eingangsklemme (i1, i2) gebildet, die mit dem Emitter eines dritten bzw. eines vierten Transistors (t3, t4) vom ersten Typ leitend verbunden ist, wobei der Kollektor des dritten bzw. vierten Transistors (t3, t4) mit dem Kollektor des ersten bzw. zweiten Transistors (t1, t2) zusammengeschaltet ist,
      - die Basis des dritten und des vierten Transistors (t3, t4) liegt gemeinsam mit dem Emitteranschluß des ersten und des zweiten Transistors (t1 , t2) an einer ersten oder einer zweiten Taktleitung (b1, b2), über die der erste oder zweite Schiebetakt (C1 , C2) zugeführt ist,
      - der gegenphasige Datenausgang (od) jeder Grundzelle (zi) ist durch eine erste und eine zweite Ausgangsklemme (o1, o2) gebildet, die mit dem Kollektor des ersten bzw. zweiten Transistors (t1 , t2) leitend verbunden ist, und

- jede Schieberegisterstufe (s1 , s2, ..., sm, ..., sn) weist für den externen Datenabgriff eine Ausgangspufferstufe (l1, ..., lm, ..., ln), auch latch genannt, auf, die als Innenschaltung die Grundzelle (zi) und eine Auskoppelstufe (la) enthält und die an eine Übernahmetaktleitung (b3) angeschlossen ist, über die ein Übernahmetakt, auchlatch-Takt genannt, (L) zugeführt ist. (Fig.1 und 2)

2. Schieberegister nach Anspruch 1, gekennzeichnet durch folgende Merkmale:
   - der Taktgenerator (g) enthält als Differenzverstärker (dv) ein emittergekoppeltes Transistorpaar aus einem elften und einem zwölften Transistor (t11, t12) von einem zweiten Typ, dessen gemeinsamer Emitteranschluß über eine Konstantstromquelle (vr, re, t13) mit einem Konstantstromquellen-Strom (Id) aus der positiven Versorgungsspannung (U) und dessen Basisanschlüsse mit einer vom Rechtecksignal (T) abhängigen Differenzspannung (Ud) gespeist sind,
   - der Kollektor des elften bzw. zwölften Transistors (t11, t12) ist über die Reihenschaltung eines ersten bzw. eines zweiten Widerstandes (r1, r2) und einer ersten bzw. einer zweiten Diode mit einem gemeisamen Bezugspotential, dem Masseanschluß (M), verbunden,
   - die erste bzw. zweite Diode ist aus einem vierzehnten bzw. einem fünfzehnten Transistor (t14, t15) vom ersten Typ gebildet, dessen gemeinsamer Kollektor-Basisanschluß aus einer ersten bzw. einer zweiten Vorstromquelle (q1 , q2) mit einem Vorstrom (Iv) gespeist ist, der um den Faktor 10 bis 1000 kleiner als der Konstantstromquellen-Strom (Id) ist,
   - der Kollektor (k1, k2) des elften bzw. zwölften Transistors (t11, t12) ist auf die Basis eines sechzehnten bzw. eines siebzehnten Transistors (t16, t17) vom ersten Typ geschaltet, dessen jeweiliger Kollektor mit der ersten bzw. mit der zweiten Taktleitung (b1, b2) verbunden ist, und
   - die Emitter des sechzehnten und siebzehnten Transistors (t16, t17) sind mit dem Masseanschluß (M) verbunden.

3. Schieberegister nach Anspruch 1, gekennzeichnet durch folgende Merkmale:
   - der zweite Transistor t2 der Grundzelle (zi) in der Ausgangspufferstufe (lm) ist als Doppelemittertransistor (t2′) ausgebildet an dessen Zusatzemitter (ez) die Auskoppelstufe (la) angeschlossen ist,
- die Auskoppelstufe (la) enthält einen siebten Transistor (t7) vom ersten Typ und einen achten Transistor (t8) vom zweiten Typ, wobei die Basis des siebten Transistors (t7) mit dem Zusatzemitter (ez) verbunden ist,
- der Emitter des siebten Transistors (t7) ist mit der Übernahmetaktleitung (b3) und der Kollektor mit einer latch-Ausgangsklemme (ol) der Ausgangspufferstufe (lm) verbunden, und
- der achte Transistor (t8) liegt mit seiner Basis an der gemeinsamen Basisleitung (bs) der Strombank (cs), mit seinem Emitter an der positiven Versorgungsspannung (U) und mit seinem Kollektor an der Basis des siebten Transistors (t7).

4. Schieberegister nach Anspruch 3, dadurch gekennzeichnet, daß der Kollektorstrom des achten Transistors (t8) etwa ein Fünftel des Stromes ist, den die Strombank (cs) als Strombankstrom (Is) an jeder Anschlußklemme abgibt.

5. Schieberegister nach Anspruch 1, dadurch gekennzeichnet, daß bei den in Sättigung gehenden Transistoren (t1, t2, t2′, t3, t4, t10, t16, t17) vom ersten Typ die Basiszone (b) von einer Ringzone (u) aus $n^+$-Material umgeben ist, die als ringförmige, laterale Zone in der Oberfläche der Kollektorwanne (w) liegt und die den jeweiligen Kollektorkontakt (kk) enthält.

6. Schieberegister nach Anspruch 2, dadurch gekennzeichnet, daß der Konstantstromquellen-Strom (= Id) und der Strombankstrom (= Is) nach folgender Bemessungsregel einzustellen sind:
$$4nIs/B \leq Id \leq 10nIS/B$$
wobei "n" die Anfahl der Schieberegisterstufen und "B" der Gleichstromverstärkungsfaktor des fünfzehnten und sechzehnten Transistors t15, t16 im Schalterbetrieb ist.

7. Schieberegister nach Anspruch 2, gekennzeichnet durch folgende Merkmale:
   - die Konstantstromquelle (vr, re, t13) des Differenzverstärkers (dv) enthält als Stromquelle einen dreizehnten Transistor (t13) vom zweiten Typ, dessen Emitter über einen Emitterwiderstand (re) an die positive Versorgungsspannung (U) angeschlossen ist,
   - die Basis des dreizehnten Transistors (t13) ist über eine temperaturkompensierte Referenzspannung (vr) mit der positiven Versorgungsspannung (U) verbunden und
   - der Kollektor des dreizehnten Transistors (t13) ist auf den gemeinsamen Emitteranschluß des Differenzverstärkers (dv) geführt.

## Claims

1. Two-phase-controlled shift register in bipolar technology, comprising
   - a clock generator (g) which derives a first shift clock (C1) and a second shift clock (C2) from an applied square-wave signal (T) by means of an emitter-coupled differential amplifier (dv), and
   - an n-stage shift-register chain (s1, s2, ..., sn) consisting of 2n series-connected basic cells (z1, z2, .... zi, zi+1, ..., z(2n-1), z(2n)) whose clock inputs (t), counted from the first basic cell (z1), are controlled alternately by the first and second shift clocks (C1, C2), with one odd-numbered basic cell (z1, z3, ..., z(2-1)) and a directly succeeding even-numbered basic cell (z2, z4, ..., z(2n)) forming a respective one (sm) of the n shift-register stages (s1, s2, ...,sm, ..., sn), and the basic cell including a first transistor (t1) and a second transistor (t2) of a first type having their emitters coupled together and each having its collector connected to the base of the respective other transistor and to one output of a current bank (cs),

   characterized by the following features:
   - The antiphase data input (di) of each basic cell (zi) is formed by a first input terminal (i1) and a second input terminal (i2) which are conductively connected to the emitters of a third transistor (t3) and a fourth transistor (t4) of the first type, respectively, whose collectors are connected to the collectors of the first and second transistors (t1, t2), respectively;
   - the bases of the third and fourth transistors (t3, t4) and the emitter terminals of the first and second transistors (t1, t2) are connected to a first or a second clock line (b1, b2) over which the first or second shift clock (C1, C2) is applied;
   - the antiphase data output (od) of each basic cell (zi) is formed by a first output terminal (o1) and a second output terminal (o2) which are conductively connected to the collectors of the first and second transistors (t1, t2), respectively, and
   - for data output, each shift-register stage (s1, s2 ..., sm, ..., sn) includes an output buffer stage (l1, ..., lm, ..., ln), also called "latch", which contains the basic cell (zi) and an output stage (la) as internal circuitry, and which is connected to a transfer-clock line (b3) via which a transfer clock (L), also called "latch clock", is applied (Figs. 1 and 2).

2. A shift register as claimed in claim 1, characterized by the following features:
   - The differential amplifier (dv) in the clock generator (g) is an emitter-coupled transistor pair consisting of an eleventh transistor (t11) and a twelfth transistor (t12) of a second type whose common emitter terminal is supplied with a constant-current-source current (Id) derived from a positive supply voltage (U) by a constant-current source (vr, re, t13), and whose base terminals are fed with a difference voltage (Ud) dependent on the square-wave signal (T);
   - the collectors of the eleventh and twelfth transistors (t11, t12) are connected to a common reference potential, the ground terminal (M), via the series combination of a first resistor (r1) and a first diode and via the series combination of a second resistor (r2) and a second diode, respectively;
   - the first and second diodes are formed by a fourteenth transistor (t14) and a fifteenth transistor (t15) of the first type, respectively, whose common collector-base terminals are fed from a first bias-current source (q1) and a second bias-current source (q2), respectively, with a bias current (Iv) which is less than the constant-current-source current (Id) by a factor of 10 to 1000;
   - the collectors (k1, k2) of the eleventh and twelfth transistors (t11, t12) are connected to the bases of a sixteenth transistor (t16) and a seventeenth transistor (t17) of the first type, respectively, whose collectors are connected to the first clock line (b1) and the second clock line (b2), respectively, and
   - the emitters of the sixteenth and seventeenth transistors (t16, t17) are connected to the ground terminal (M).

3. A shift register as claimed in claim 1, characterized by the following features:
   - The second transistor (t2) of the basic cell (zi) in the latch (lm) is a dual-emitter transistor (t2′) having the output stage (la) connected to its additional emitter (ez);
   - the output stage (la) contains a seventh transistor (t7) of the first type and an eighth transistor (t8) of the second type, with the base of the seventh transistor (t7) connected to the additional emitter (ez);
   - the emitter of the seventh transistor (t7) is connected to the transfer-clock line (b3), and the collector to a latch output terminal (ol) of the output buffer stage (lm), and
- the eighth transistor (t8) has its base connected to the common base lead (bs) of the current bank (cs), its emitter to the positive supply voltage (U), and its collector to the base of the seventh transistor (t7).

4. A shift register as claimed in claim 3, characterized in that the collector current of the eighth transistor (t8) is about one fifth of the current delivered by the current bank (cs) as a current-bank current (Is) at each of its output terminals.

5. A shift register as claimed in claim 1, characterized in that in the transistors (t1, t2, t2', t3, t4, t10, t16, 17) of the first type which go into saturation, the base region (b) is surrounded by an annular region (u) of $n^+$-type material which is let as a lateral region into the surface of the collector well (w) and includes the respective collector contact (kk).

6. A shift register as claimed in claim 2, characterized in that the constant-current-source current (= Id) and the current-bank current (= Is) are adjusted in accordance with the following rule:

$$4nIs/B \leqq Id \leqq 10nIS/B$$

where "n" is the number of shift register stages, and "B" is the DC gain of the fifteenth and sixteenth transistors (t15, t16) in the switch mode.

7. A shift register as claimed in claim 2, characterized by the following features:
- The constant-current source (vr, re, t13) of the differential amplifier (dv) contains as a current source a thirteenth transistor (t13) of the second type which acts as a current source and has its emitter connected via an emitter resistor (re) to the positive supply voltage (U);
- the base of the thirteenth transistor (t13) is connected to the positive supply voltage (U) via a temperature-compensated reference-voltage source (vr), and
- the collector of the thirteenth transistor (t13) is connected to the common emitter terminal of the differential amplifier (dv).

## Revendications

1. Registre à décalage commandé sur deux phases, réalisé selon la technique bipolaire et comportant
- un générateur de cadence (g), qui, au moyen d'un amplificateur différentiel (dv) à émetteurs couplés, produit, à partir d'un signal rectangulaire envoyé (T), des première et seconde cadences de transfert (C1, C2),
- une chaîne (s1, s2, ..., sn) du registre à décalage à n étages, qui est constituée de 2n cellules de base (z1, z2, ..., zi, zi+1, ..., z(2n-1), z(2n)), branchée en série et dont une entrée respective de cadence (t) est commandée alternativement par la première ou la seconde cadence de transfert (C1, C2), d'une manière comptée à partir de la première cellule de base (z1), respectivement une cellule de base impaire (z1, z3, ..., z(2n-1)) et une cellule de base paire (z2, z4, ..., z(2n)) immédiatement suivante formant l'un (sm) des n étages du registre à décalage (s1, s2, ..., sm, ..., sn), tandis que la cellule de base contient des premier et second transistors (t1, t2) d'un premier type à émetteurs couplés, dont le collecteur respectif est relié à la base de l'autre transistor et respectivement à une sortie d'un bloc de production de courant (cs),
caractérisé par les caractéristiques suivantes :
- l'entrée de données en opposition de phase (di), de chaque cellule de base (zi) est formée par des première et seconde bornes d'entrée (i1, i2), qui sont reliées de façon conductrice à l'émetteur d'un troisième ou d'un quatrième transistor (t3, t4) du premier type, le collecteur du troisième ou du quatrième transistor (t3, t4) étant relié au collecteur du premier ou du second transistor (t1, t2),
- la base des troisième et quatrième transistors (t3, t4) est raccordée en commun à la borne d'émetteur des premier et second transistors (t1, t2) au moyen d'une première et d'une seconde ligne de transmission de cadence (b1, b2), au moyen de laquelle la première ou la seconde cadence de transfert (C1, C2) est envoyée,
- la sortie de données en opposition de phase (od), de chaque cellule de base (zi) est formée par des première et seconde bornes de sortie (o1, o2), qui sont raccordées de façon conductrice au collecteur du premier ou du second transistor (t1, t2), et
- chaque étage à registre à décalage (s1, s2, ..., sm, ..., sn) possède, pour le prélèvement externe de données, un étage tampon de sortie (l1, ..., lm, ..., ln), également désigné sous le terme circuit de verrouillage , qui contient en tant que circuit intérieur la cellule de base (zi) et un étage de découplage (la) et qui est raccordé à une ligne (b3) de transmission de la cadence de transfert, au moyen de laquelle une cadence de prise en charge, également désignée sous le terme de cadence de verrouillage, (L) est envoyée. (Figure 1 et 2).

2. Registre à décalage suivant la revendication 1, caractérisé par les caractéristiques suivantes :
- le générateur de cadence (g) contient, en tant qu'amplificateur différentiel (dv), un couple de transistors à émetteurs couplés constitués par des onzième et douzième transistors (t11, t12) d'un second type, dont la borne d'émetteur commune est alimentée par l'intermédiaire d'une source de courant constant (vr, re, t13) par un courant (Id) à partir de la tension d'alimentation positive (U), et dont les bornes de base sont alimentées par une tension différentielle (Ud) qui dépend du signal rectangulaire (T),
- le collecteur du onzième ou douzième transistor (t11, t12) est relié par l'intermédiaire du montage série d'une première ou d'une seconde résistance (r1, r2) et d'une première ou d'une seconde diode, à un potentiel de référence commun, à la borne de masse (M),
- la première ou la seconde diode est formée par un quatorzième ou un quinzième transistor (t14, t15) du premier type, dont la borne commune de collecteur - base est alimentée par une première ou une seconde source de courant de polarisation (q1, q2), avec un courant de polarisation (Iv), qui est inférieur, du facteur 10 à 1000, au courant (Id) de la source de courant constant,
- le collecteur (k1, k2) du onzième ou du douzième transistor (t11, t12) est raccordé à la base d'un seizième ou d'un dix-septième transistor (t16, t17) du premier type, dont le collecteur respectif est relié a la première ou à la seconde ligne de transmission de cadence (b1, b2), et les émetteurs des seizième et dix-septième transistors (t16, t17) sont reliés à la borne de masse (M).

3. Registre à décalage suivant la revendication 1, caractérisé par les caractéristiques suivantes :
- le second transistor (t2) de la cellule de base (zi) situé dans l'étage tampon de sortie (lm) est réalisé sous la forme d'un transistor à émetteur double (t2'), à l'émetteur supplémentaire (ez) duquel est raccordé l'étage de découplage (la),
- l'étage de découplage (la) contient un septième transistor (t7) du premier type et un huitième transistor (t8) du second type, la base du septième transistor (t7) étant reliée à l'émetteur supplémentaire (tz),
- l'émetteur du septième transitor (t7) est relié à la ligne de transmission de cadence de prise en charge (b3) et le collecteur est relié à une borne de sortie de verrouillage (ol) de l'étage tampon de sortie (lm), et
- le huitième transistor (t8) est raccordé par sa base à la ligne de base commune (bs) du bloc de production de courant (cs), par son émetteur à la tension d'alimentation positive (U) et par son collecteur à la base du septième transistor (t7).

4. Registre à décalage suivant la revendication 3, caractérisé par le fait que le courant de collecteur du huitième transistor (t8) est égal approximativement à un cinquième du courant que le bloc de production de courant (cs) délivre en tant que courant (Is) à chaque borne de raccordement.

5. Registre à décalage suivant la revendication 1, caractérisé par le fait que dans le cas des transistors (t1, t2, t2', t3, t4, t10, t16, t17) du premier type, qui passent à la saturation, la zone de base (b) est entourée par une zone annulaire (u) formée d'un matériau de type $n^+$, qui est présent sous la forme d'une zone latérale annulaire dans la surface de la cuvette (w) du collecteur et qui contient le contact respectif de collecteur (kk).

6. Registre à décalage suivant la revendication 2, caractérisé par le fait que le courant (= Id) de la source de courant constant et le courant (= Is) du bloc d'alimentation en courant doivent être réglés conformément aux règles suivantes de dimensionnement :
$$4nIs/b \leqq Id \leqq 10 \, nIS/B$$
"n" désignant le nombre des étages du registre à décalage et "V" le facteur d'amplification en courant continu des quinzième et seizième transistors (t15, t16) dans le fonctionnement en commutateur.

7. Registre à décalage suivant la revendication 2, caractérisé par les caractéristiques suivantes :
- la source de courant constant (vr, re, t13) de l'amplificateur différentiel (dv) contient, en tant que source de courant, un treizième transistor (t13) du second type, dont l'émetteur est placé par l'intermédiaire d'une résistance d'émetteur (re) à la tension d'alimentation positive (U), la base du treizième transistor (t13) est placée par l'intermédiaire d'une tension de référence (vr) compensée en température, à la tension d'alimentation positive (U), et le collecteur du treizième transistor (t13) est raccordé à la borne commune d'émetteur de l'amplificateur différentiel (dv).

s1   s2   sm   sn

P1   P2   ol   Pm   b3   Pn

L

la

t   di

lm   ln

l1   l2   od

z2   z4   zi+1   z(2n)

di   od

z1   z3   zi

t

C2

zi   di   od

di

z(2n-1)

T

C2

b2

b1

g

C1

sr

Di   Dq

**FIG. 1**

FIG. 2

**FIG. 5**

**FIG. 3**

**FIG. 4**

**FIG. 6**

EP 0 413 038 B1